# EUROPÄISCHE PATENTSCHRIFT

(11) **EP 1 249 044 B1**
(45) Veröffentlichungstag und Bekanntmachung des Hinweises auf die Patenterteilung: **14.03.2007**
(21) Anmeldenummer: 00991213.0
(22) Anmeldetag: 19.12.2000
(51) Int. Cl.: H01L 31/173

(54) **OPTISCHE SENDE- UND EMPFANGSEINRICHTUNG UND DEREN HERSTELLUNGSVERFAHREN**
METHOD FOR PRODUCING AN OPTICAL TRANSMITTING AND RECEIVING DEVICE AND A TRANSMITTING AND RECEIVING DEVICE PRODUCED ACCORDING TO SAID METHOD
PROCEDE DE PRODUCTION D'UN DISPOSITIF D'EMISSION ET DE RECEPTION OPTIQUE ET DISPOSITIF D'EMISSION ET DE RECEPTION OPTIQUE AINSI PRODUIT

(30) Priorität: 22.12.1999 DE 19962442
(43) Veröffentlichungstag der Anmeldung: 16.10.2002
(73) Patentinhaber: Micronas GmbH, 79108 Freiburg i. Br. (DE)
(72) Erfinder: SIEBEN, Ulrich, 79276 Reute (DE); IGEL, Günter, 79331 Teningen (DE)
(74) Vertreter: Huwer, Andreas
(86) Internationale Anmeldenummer: PCT/EP2000/012936
(87) Internationale Veröffentlichungsnummer: WO 2001/047034

(56) Entgegenhaltungen:
- WO-A-93/22644
- WO-A-97/42478
- DE-A- 19 635 215
- US-A- 3 881 113
- US-A- 5 039 490
- US-A- 5 629 534
- PATENT ABSTRACTS OF JAPAN vol. 1998, no. 13, 30. November 1998 (1998-11-30) -& JP 10 223925 A (MATSUSHITA ELECTRIC WORKS LTD), 21. August 1998 (1998-08-21)
- PATENT ABSTRACTS OF JAPAN vol. 1997, no. 08, 29. August 1997 (1997-08-29) -& JP 09 089773 A (HORIBA LTD), 4. April 1997 (1997-04-04)

## Beschreibung

Die Erfindung betrifft eine optische Sende- und Empfangseinrichtung nach dem Oberbegriff von Anspruch 1 sowie nach dem Oberbegriff von Anspruch 2.

Aus WO 97/42478 A ist ein Drucksensor mit einer optischen Sende- und Empfangseinrichtung bekannt, die ein Licht emittierendes Sendeelement und ein dieses Licht in eine elektrische Größe umsetzendes Empfangselement aufweist. Das Licht-Sendeelement und das Licht-Empfangselement sind jeweils als Halbleiterbauelement in einen Siliziumchip integriert Der das Licht-Sendeelement aufweisende Siliziumchip ist mit seiner Licht aussendenden Seite der Licht empfangenden Seite des anderen Siliziumchips zugewandt. Zwischen den Siliziumchips ist eine Distanzschicht angeordnet, die eine im Lichtübertragungsweg zwischen dem Sendeelement und dem Empfangselement angeordnete Kavität umgrenzt Der das Sendeelement aufweisende Siliziumchip kann auch direkt auf dem das Empfangselement aufweisenden Siliziumchip angeordnet sein. In diesem Fall ist die Kavität in dem das Sendeelement aufweisenden Siliziumchip vorgesehen. Die Dicke der Kavität ist so bemessen, dass in der Kavität Interferenz auftritt Die Interferenz und somit auch das von dem Licht-Empfangselement abgegebene elektrische Signal sind von dem außerhalb der Kavität auf den Drucksensor einwirkenden Umgebungsdruck abhängig.

Aus WO93/22644 ist eine Vorrichtung mit Sende- und Empfangseinrichtung und einer Kavität bekannt.

Aus "Sensors and Actuators A, 31 (1992) S229-240" ist ferner ein Optokoppler bekannt, dessen Lichtquelle eine Avalanche-Silizium-Diode Ist Der Optokoppler weist auf einem Substrat nebeneinander angeordnet die Avalanchediode als Lichtquelle und den Lichtdetektor In Form einer Photodiode auf Durch diese Anordnung wird eine vergleichsweise große Chipfläche benötigt. Außerdem sind Sender und Empfänger nicht dielektrisch voneinander getrennt. Schließlich sind Maßnahmen erforderlich, die eine möglichst verlustarme Lichtleitung zwischen Sender und Empfänger begünstigen, was den Herstellungsaufwand erhöht.

Aufgabe der vorliegenden Erfindung ist es, eine optische Sende- und Empfangseinrichtung zu schaffen, die eine Vielzahl von Anwendungen ermöglicht

Diese Aufgabe wird sowohl mit den Merkmalen des Anspruchs 1 als auch mit den Merkmalen des Anspruchs 2 gelöst.

Durch die sandwichartig übereinander angeordneten Sende- und Empfangselemente wird einerseits der Platzbedarf an Chipfläche erheblich reduziert (nahezu halbiert) und außerdem ist der Abstand zwischen den beiden Elementen geringstmöglich, so dass Übertragungsverluste minimiert sind beziehungsweise der Übertragungswirkungsgrad wesentlich verbessert ist Dadurch kann die Leistung des Sende-Elementes sehr klein sein, ohne dass sich dies auf die Funktion nachteilig auswirkt. Insbesondere ist die gegenüber Galliumarsenid-Systemen reduzierte Lichtintensität des auf Sillziumbasis aufgebauten Sendeelementes für eine sichere Funktion auch schon bei kleinen Betriebsströmen ausreichend.

Vorteilhaft ist auch die elektrische Trennung der Systeme durch die isolierende Zwischenschicht, was bei Einsatz der Einrichtung zum Beispiel als Optokoppler gefordert ist.

Durch die von außen zugängliche Kavität lässt sich ein sehr kompaktes Analysesystem schaffen. Dabei sind Untersuchungen an Flüssigkeiten und Gasen, die sich In der Kavität befinden, möglich.

Zusätzliche Ausgestaltungen der Erfindung sind in den Unteransprüchen aufgeführt, Nachstehend ist die Erfindung mit ihren wesentlichen Einzelheiten anhand der Zeichnungen noch näher erläutert. Es zeigt etwas schematisiert
- Fig.1: einen Querschnitt durch eine optische Sende- und Empfangseinrichtung und
- Fig.2: einen Querschnitt durch eine optische Sende- und Empfangseinrichtung, die im Lichtübertragungsweg eine Kavität aufweist

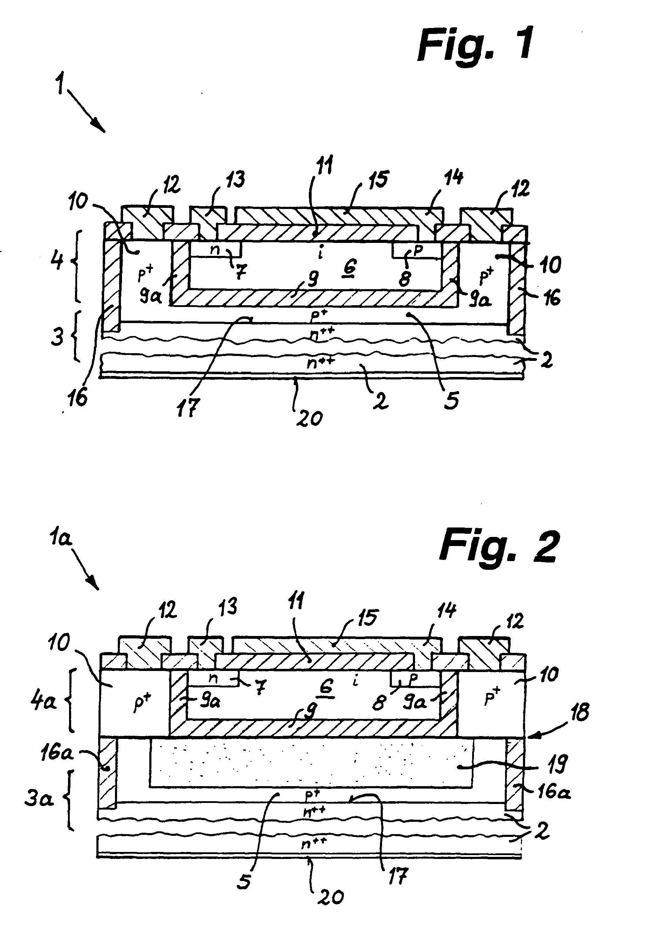

Eine in Fig.1 gezeigte, optische Sende- und Empfangseinrichtung 1 weist auf einem Substrat 2 eine Schichtfolge für ein Sendeelement 3 und darüber angeordnet eine Schichtfolge für ein Empfangselement 4 auf

Zur Bildung des Sendeelementes 3 ist auf dem hochdotierten Silizium-Substrat 2 eines ersten Dotierungstyps eine Epitaxieschicht 5 eines zweiten Dotierungstyps aufgebracht. Die Sperrschicht zwischen diesen beiden Schichten ist der Bereich der Lichtemission.

Nach dem Aufbringen einer Intrinsicschicht 6 auf die Epitaxieschicht 5 wird eine bis zur Epitaxieschicht 5 des Sendeelementes 3 reichende Schicht 10 des gleichen Dotierungstyps eindiffundiert. Damit ist der eine Pol, im Ausführungsbeispiel die Anode des Sendeelementes 3 zur Oberseite des Chips geführt.
Die metallisierte Unterseite des Silizium-Substrates 2 bildet im vorliegenden Ausführungsbeispiel den Kathodenanschluß 20 des Sendeelementes 3. Bedarfsweise kann dieser Anschlußkontakt auch zur Oberseite der Anordnung geführt sein.

Im Ausführungsbeispiel ist das Empfangselement 4 durch eine pin-Diode mit der Intrinsic-Schicht 6 und darin seitlich zueinander beabstandeten Diffusionszonen 7, 8 gebildet. Zur Herstellung des Empfangselementes 4 wird auf die Epitaxieschicht 5 des Sendeelementes die Intrinsicschicht 6 aufgebracht und die beiden Zonen 7 und 8 eindiffundiert. Zur galvanischen Trennung des Sendeelementes 3 von dem Empfangselement 4 wird dazwischen eine dielektrische Zwischenschicht 9, 9a eingebracht. Die Zwischenschicht ist durch eine Oxidschicht gebildet.
Der horizontale Zwischenschichtabschnitt 9 wird durch Sauerstoffimplantation nach dem SIMOX-Verfahren gebildet.
Die seitlichen Zwischenschichtabschnitte 9a werden durch Trench-Ätzen und Trench-Verschließen gebildet.

Die Oberseite der Intrinsicschicht 6 wird mit einer Oxidschicht 11 als Schutzschicht versehen. Schließlich wird die Oberfläche in einem üblichen Kontaktierungsverfahren mit Anschlußkontakten versehen, wobei die metallisierte Oberseite der Schicht 10 den Anodenanschluß 12 des Sendeelementes 3 bildet. Die metallisierten Oberseiten der beiden Diffusionszonen 7 und 8 bilden den Kathodenanschluß 13 und den Annodenanschluß 14 des Empfangselementes 4. Gut zu erkennen ist noch, daß sich der Annodenanschluß 14 über die Rückseite des Empfangselementes 4 erstreckt. Damit ist eine als Reflektor 15 dienende Metallschicht gebildet.

Diese metallische Reflektionsschicht verbessert den Wirkungsgrad des Empfangselementes.
Der Reflektor 15 kann auch von den übrigen Kontaktmetallisierungen getrennt sein.

Werden mehrere Sende- und Empfangseinrichtungen 1 auf einem gemeinsamen Substrat nebeneinander angeordnet, ist zur Systemtrennung eine Oxidschicht 16 vorgesehen, die insbesondere durch Trench-Ätzen und Trench-Verschließen gebildet wird und sich von der Chip-Oberseite bis über die Sperrschicht 17 des Sendeelementes 3 hinaus erstreckt.
Die Oxidschicht 16 wird gleichzeitig mit der Zwischenschicht 9a eingebracht. Dabei wird beim Trench-Ätzen die Ätzung für die Gräben der Zwischenschicht 9 automatisch gestoppt, wenn das Ätzmittel (Ätzgas) auf die horizontale Silizium-Oxidschicht 9 auftrifft. Die dazu benachbarten äußeren Gräben, die gleichzeitig mithergestellt werden, treffen nicht auf eine solche Siliziumoxidschicht, so daß sie tiefer eingebracht werden können, über die Sperrschicht 17 reichen und dann eine entsprechende Systemtrennung bewirken.

Die erfindungsgemäße Anordnung von Sendeelement 3 und Empfangselement 4 mit sandwichartiger Schichtung übereinander ergibt einen sehr kurzen Licht-Übertragungsweg, in dem sich praktisch nur die isolierende Zwischenschicht 9 befindet. Durch den kurzen Übertragungsweg genügt auch schon eine geringe Intensität des vom Sendeelement 3 abgestrahlten Lichtes beziehungsweise es kann mit sehr geringen Strömen für das Sendeelement 3 gearbeitet werden.

Das durch eine pin-Diode gebildete Empfangselement 4 weist eine extrem hohe Lichtempfindlichkeit und damit einen hohen Wirkungsgrad auf. Auch dies trägt mit dazu bei, daß senderseitig mit einer sehr geringen Lichtleistung gearbeitet werden kann. Unterstützt wird dies auch noch durch die als Reflektor 15 dienende Metallschicht rückseitig des Empfangselementes 4. Diese Schicht kann wie die Kontakte 12 bis 14 aus Aluminium, gegebenenfalls aber auch aus Gold oder einem anderen Metall mit guter Lichtreflektion bestehen.

Die Sende- und Empfangseinrichtung 1 kann nebeneinander in Vielfachausführung vorgesehen sein, um beispielsweise eine Mehrkanal-Anordnung zur Lichtübertragung zu realisieren.

Erwähnt sei noch, daß das Empfangselement 4 auch durch einen Phototransistor, einen Photothyristor, einen Photowiderstand oder dergleichen lichtempfindliches Element gebildet sein. Es besteht auch die Möglichkeit, empfängerseitig einen nachgeschalteten Leistungsschalter zu integrieren, um damit beispielsweise ein Photo-MOS-Relais zu schaffen.

Die in Fig.1 gezeigte Sende- und Empfangseinrichtung 1 kann beispielsweise als Optokoppler verwendet werden.

Fig.2 zeigt eine abgewandelte Ausführungsform einer erfindungsgemäßen Sende- und Empfangseinrichtung 1a. Für das Sendeelement 3a und das Empfangselement 4a sind in diesem Ausführungsbeispiel zunächst voneinander getrennte, separate Silizium-Chips vorgesehen. Diese werden nach ihrer Herstellung mit der Licht aussendenden und der Licht empfangenden Seite einander zugewandt im Verbindungsbereich 18 durch Chip-Bonden miteinander verbunden, so daß sich dann eine etwa mit der Ausführungsform nach Fig.1 vergleichbare Anordnung ergibt, wobei insbesondere auch hier die Schichtungen des Sendeelementes 3 und die Schichtungen des Empfangselementes 4 sandwichartig übereinander angeordnet sind.

Bei der in Fig.2 gezeigten Ausführungsform befindet sich im Lichtübertragungsweg zwischen Sendeelement 3a und Empfangselement 4a eine Kavität 19, die vorzugsweise von außen zugänglich ist. Im Ausführungsbeispiel ist die Kavität 19 durch Entfernen von Silizium aus der Epitaxieschicht 5 gebildet. Da diese Seite des Sendechips vor dem Verbinden mit dem Empfängerchip frei zugänglich ist, kann die Kavität 19 auf einfache Weise hergestellt werden. Auch die durch eine Oxidschicht gebildete, isolierende Zwischenschicht 9 kann wegen der Zugänglichkeit der Empfängerchip-Seite vor dem Bonden einfacher realisiert werden, als bei der Ausführungsform nach Fig.1. Gegebenenfalls kann auf die isolierende Zwischenschicht 9 verzichtet werden, wenn sich in der Kavität 19 ein Gas befindet, so daß dadurch eine ausreichende Isolation und galvanische Trennung zwischen den Systemen vorhanden ist.
Beschichtungen im Lichtübertragungsweg können außer zu Isolationszwecken auch für andere Aufgaben vorgesehen sein. So besteht die Möglichkeit, eine wellenlängenselektive Filterschicht zum Beispiel aus Siliziumnitrit vorzusehen, durch die nur Licht mit einer Wellenlänge oberhalb von 400 nm durchgelassen wird.
Außer solchen wellenlängenselektiven Filterschichten lassen sich andere, praktisch beliebige Beschichtungen aufbringen um die Lichtübertragung zwischen dem Sendeelement 3a und dem Empfangselement 4a zu beeinflussen.

Die von außen zugängliche Kavität 19 kann mit einem gasförmigen oder flüssigen Medium gefüllt oder durchströmt werden. So ist es möglich, mittels Photoabsorption die Stoffart zu bestimmen, das Material als Filter zu benutzen usw. Somit lassen sich Untersuchungen an diesen Medien durchführen, wobei in Abhängigkeit des jeweiligen Stoffes die auftretende Meßreaktion erfaßt wird. Beispielsweise besteht die Möglichkeit, spektrometrische Untersuchungen durchzuführen oder die Medien auf Trübung zu überwachen. Dadurch eröffnet sich die Möglichkeit der Überwachung beispielsweise der Wasserqualität oder des Einsatzes als Brandmelder, wo durch Rauch oder eine veränderte Zusammensetzung der Raumluft eine Beeinflussung der Lichtübertragung erfolgt.

Durch die Anordnung von Sendeelement 3a, Kavität 19 und Empfangselement 4a In einem vorzugsweise zusammengesetzten Chip ist somit ein sehr kompaktes Analysesystem geschaffen.

Bei der Ausführungsform gemäß Fig.1 ist ebenfalls eine Kavität im Lichtübertragungsweg vorgesehen, die beispielsweise durch Unterätztechnik hergestellt wird. Wegen des höheren Herstellungsaufwandes bei dem Ausführungsbeispiel nach Fig.1 sind dort vorzugsweise eine oder mehrere Mikrokavitäten vorgesehen, während bei der Ausführungsform nach Fig.2 wegen der Zugänglichkeit der Innenseiten der beiden Chips eine oder mehrere Kavitäten in beliebiger Größe und Form vorgesehen sein können.
In diesem Zusammenhang sei auch noch erwähnt, daß die Kavität 19 nicht nur im Sendeelemente-Chip sondern auch im Empfangselement-Chip vorgesehen sein kann.

Durch die Herstellung der Sende- und Empfangseinrichtung 1 und 1a in Siliziumtechnik, lassen sie sich gut in andere Siliziumsysteme integrieren. Da die Anordnungen weitgehend gegen Fremdlicht geschützt sind, ist auch eine Flip-Chip-Montage möglich.

## Patentansprüche

1. Optische Sende- und Empfangseinrichtung mit einem Licht emittierenden Sendeelement (3, 3a) sowie mit einem dieses Licht in eine elektrische Größe umsetzenden Empfangselement (4, 4a), wobei die Sende- und Empfangselemente (3, 4) übereinander liegend angeordnet sind und zwischen ihnen eine dielektrische Zwischenschicht (9, 9a) angeordnet ist, und wobei die Sende- und Empfangseinrichtung zwischen Sendeelement (3, 3a) und Empfangselement (4, 4a) wenigstens eine Kavität (19) aufweist, **dadurch gekennzeichnet, dass** Sende- und Empfangselemente (3,4) in einem gemeinsamen Siliziumsubstrat angeordnet sind, und dass die Kavität (19) von außen zugänglich ist

2. Optische Sende- und Empfangseinrichtung mit einem Licht emittierenden Sendeelement (3, 3a) sowie mit einem dieses Licht in eine elektrische Größe umsetzenden Empfangselement (4, 4a), wobei für das Licht-Sendeelement (3a) und für das Licht-Empfangselement (4a) jeweils ein Siliziumchip vorgesehen ist, wobei diese Chips einerseits mit der Licht aussendenden und andererseits mit der Licht empfangenden Seite einander zugewandt verbunden sind und wobei im Lichtübertragungsweg zwischen Sendeelement und Empfangselement wenigstens eine Kavität (19) angeordnet ist, **dadurch gekennzeichnet, dass** die Kavität (19) von außen zugänglich ist

3. Optische Sende- und Empfangseinrichtung nach einem der Anspruch 1 oder 2, **dadurch gekennzeichnet, dass** das Licht-Empfangselement (4, 4a) eine pin-Diode ist.

4. Optische Sende- und Empfangseinrichtung nach einem der Ansprüche 1 bis 3, **dadurch gekennzeichnet dass** sie als Optokoppler, gegebenenfalls mit einem empfängerseitig vorgesehenen Leistungsschalter ausgebildet ist.

5. Optische Sende- und Empfangseinrichtung nach einem der Ansprüche 1 bis 4, **dadurch gekennzeichnet, dass** die Sende- und Empfangseinrichtung
- als Analysesystem für spektrometrische Untersuchungen,
- als Brandmelder oder
- zur Untersuchung von Flüssigkeiten ausgebildet ist.

## Claims

1. Optical transmitting and receiving device having a light-emitting transmitting element (3, 3a) and a receiving element (4, 4a) which converts said light into an electrical variable, wherein the transmitting and receiving elements (3, 4) are arranged in a manner such that they lie one above the other, and a dielectric intermediate layer (9, 9a) is arranged between them and wherein the transmitting and receiving device has at least one cavity (19) between transmitting element (3, 3a) and receiving element (4, 4a), **characterized in that** transmitting and receiving elements (3, 4) are arranged in a common silicon substrate, and **in that** the cavity (19) can be accessed from the outside.

2. Optical transmitting and receiving device having a light-emitting transmitting element (3, 3a) and a receiving element (4, 4a) which converts said light into an electrical variable, wherein a respective silicon chip is provided for the light-transmitting element (3a) and for the light-receiving element (4a), wherein said chips are connected such that their light-emitting side, on the one hand, and their light-receiving side, on the other hand, face each other, and wherein at least one cavity (19) is arranged in the light-transmission path between transmitting element and receiving element, **characterized in that** the cavity (19) can be accessed from the outside.

3. Optical transmitting and receiving device according to either of Claims 1 and 2, **characterized in that** the light-receiving element (4, 4a) is a pin diode.

4. Optical transmitting and receiving device according to one of Claims 1 to 3, **characterized in that** it is in the form of an optocoupler, if appropriate having a power switch provided on the receiver side.

5. Optical transmitting and receiving device according to one of Claims 1 to 4, **characterized in that** the transmitting and receiving device is
- in the form of an analysis system for spectrometric examinations,
- in the form of a fire detector or
- designed to examine liquids.

## Revendications

1. Dispositif d'émission et de réception optique avec un élément d'émission émetteur de lumière (3, 3a) ainsi qu'avec un élément de réception (4, 4a) convertissant cette lumière en une grandeur électrique, les éléments d'émission et de réception (3, 4) étant disposés de façon superposée, et une couche intermédiaire diélectrique (9, 9a) étant disposée entre ceux-ci, et dans lequel le dispositif d'émission et de réception présente entre l'élément d'émission (3, 3a) et l'élément de réception (4, 4a) au moins une cavité (19), **caractérisé en ce que** les éléments d'émission et de réception (3, 4) sont disposés dans un substrat de silicium commun et **en ce que** la cavité (19) est accessible depuis l'extérieur.

2. Dispositif d'émission et de réception optique avec un élément d'émission émetteur de lumière (3, 3a) ainsi qu'avec un élément de réception (4, 4a) convertissant cette lumière en une grandeur électrique, dans lequel respectivement une puce de silicium est prévue pour l'élément d'émission de lumière (3a) et pour l'élément de réception de lumière (4a), dans lequel ces puces sont reliées d'une part au côté émettant la lumière et d'autre part au côté recevant la lumière, en étant tournées l'une vers l'autre, et dans lequel dans le trajet de transmission de lumière entre l'élément d'émission et l'élément de réception, au moins une cavité (19) est disposée, **caractérisé en ce que** la cavité (19) est accessible depuis l'extérieur.

3. Dispositif d'émission et de réception optique selon l'une quelconque des revendications 1 ou 2, **caractérisé en ce que** l'élément de réception de lumière (4, 4a) est une diode PIN.

4. Dispositif d'émission et de réception optique selon l'une quelconque des revendications 1 à 3, **caractérisé en ce qu'**il est réalisé comme un coupleur optique, éventuellement avec un disjoncteur prévu côté réception.

5. Dispositif d'émission et de réception optique selon l'une quelconque des revendications 1 à 4, **caractérisé en ce que** le dispositif d'émission et de réception est réalisé
- comme un système d'analyse pour des analyses spectrométriques,
- comme un détecteur d'incendie ou
- pour l'analyse de liquides.
